(19)

Europäisches
Patentamt

European
Patent Office

Office européen
des brevets

(11) **EP 4 550 613 A1**

(12) **EUROPEAN PATENT APPLICATION**

(43) Date of publication:
**07.05.2025 Bulletin 2025/19**

(21) Application number: **24166082.8**

(22) Date of filing: **25.03.2024**

(51) International Patent Classification (IPC):
**H02J 7/00** *(2006.01)*

(52) Cooperative Patent Classification (CPC):
**H02J 7/0047; H02J 7/0014; H02J 7/00309;
H02J 7/0031; H02J 7/005; H02J 7/007184;
H02J 7/007194**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.11.2023 KR 20230150497**

(71) Applicant: **Samsung SDI Co., Ltd.**
**Yongin-si, Gyeonggi-do 17084 (KR)**

(72) Inventor: **KIM, Dolores**
**Suwon-si 16678 (KR)**

(74) Representative: **Marks & Clerk LLP**
**15 Fetter Lane**
**London EC4A 1BW (GB)**

(54) **APPARATUS AND METHOD FOR DIAGNOSING AND MANAGING STATE OF BATTERY**

(57)    The present disclosure relates to an apparatus and method for diagnosing and managing a state of a battery, and is directed to providing an apparatus and method for diagnosing and managing a state of a battery capable of shortening the time for diagnosing and managing of the state of battery cells and further improving the accuracy of determination. To this end, the present disclosure provides an apparatus for diagnosing and managing a state of a battery including: a sensor module configured to detect a temperature and a voltage of a battery; and a processor configured to calculate a cell delta voltage based on the temperature or voltage of the battery detected through the sensor module, calculate a differential value of the temperature, voltage, or cell delta voltage, and diagnose an abnormal battery cell or limit battery charging power based on a result of comparing a specific value calculated by substituting the differential value into a specified equation and a pre-specified threshold value.

FIG.1

EP 4 550 613 A1

**Description**

**BACKGROUND**

**1. Field**

Aspects of embodiments of the present disclosure relate to an apparatus and method for diagnosing and managing a state of a battery.

**2. Description of the Related Art**

Generally, a battery pack is composed of a plurality of battery cells, and a battery management system (BMS) monitors the performance and safety of the battery cells.

The battery management system (BMS) monitors the voltage and temperature of the battery cells, and based on this, performs battery cell management, state of charge (SOC) prediction, limitation of input and output power for protection from overheating/overcharging/over-discharging, power relay assembly (PRA) control, fault diagnosis, and the like.

Battery cell management is a function that adjusts the voltage of each cell and manages the battery to prevent overload of the battery. When a specific battery cell malfunctions or does not operate, the battery management system (BMS) performs control so that another battery cell can replace the function of the specific battery cell through cell balancing.

The battery management system (BMS) detects the voltage, current, and temperature of the battery to predict a state of charge, and based on this, allows a battery level to be checked. The SOC sets an upper limit and a lower limit according to a preset availability zone, and in the case of deviating from the availability zone, the battery management system (BMS) blocks the charging of the battery.

In order to stably operate the battery, an upper limit (an end-of-charge voltage) and a lower limit (an end-of-discharge voltage) of the charged battery voltage are set, and the battery management system (BMS) stops charge and discharge of the battery when the voltage of the battery deviates from the end-of-charge voltage or end-of-discharge voltage.

When a high-voltage battery of an electric vehicle malfunctions or becomes uncontrollable, the battery management system (BMS) turns off a relay to block power supply to protect the high-voltage battery and prevent the risk of occurrence of a larger accident.

Further, the battery management system (BMS) diagnoses a malfunction in a battery system, and, specifically, detects operational abnormalities such as an overvoltage/undervoltage, a malfunctioning battery cell, an overcurrent/undercurrent, an overheating condition, a disconnection, a short circuit, a malfunctioning cooling fan, loss of communication, and the like and transmits a diagnostic trouble code (DTC) to another controller.

As described above, the battery management system (BMS) performs diagnosing and managing of the state of the battery cells, and as the performance of these diagnosis and management operations is delayed or the accuracy of determination deteriorates, the more the risk of an accident increases.

Accordingly, there is a need for a method for further shortening the time for diagnosing and managing of the state of the battery cells and further improving the accuracy of determination.

The above-described information disclosed in the background technology of this invention is only for improving understanding of the background of the present invention, and accordingly, can include information which does not constitute the related art.

**SUMMARY**

The present invention is directed to providing an apparatus and method for diagnosing and managing a state of a battery capable of shortening the time for diagnosing and managing of the state of battery cells and further improving the accuracy of determination.

Further, the present invention is directed to providing an apparatus and method for diagnosing and managing a state of a battery capable of detecting a temperature of battery cells, extracting a differential value of the temperature, and controlling the temperature of the battery cells according to the extracted differential value to prevent overheating of the battery cells.

In addition, the present invention is directed to providing an apparatus and method for diagnosing and managing a state of a battery capable of determining the occurrence of a cell imbalance based on a differential value of a cell delta voltage and performing cell balancing and current control.

In addition, the present invention is directed to providing an apparatus and method for diagnosing and managing a state of a battery capable of detecting an abnormal cell based on the distribution of a differential value of a cell delta voltage over time to exclude the influence of cell balancing and effectively detect the abnormal cell.

However, technical problems to be solved by the present invention are not limited to the above-described problems, and other problems, which are not mentioned, will be clearly understood by those skilled in the art from the description of the invention disclosed below.

According to an aspect of the present invention, there is provided an apparatus for diagnosing and managing a state of a battery, the apparatus including: a sensor module configured to detect a temperature and a voltage of the battery; and a processor configured to calculate a cell delta voltage based on the temperature or voltage of the battery detected through the sensor module, calculate a differential value of the temperature, voltage, or cell delta voltage, and diagnose an abnormal battery cell or limit battery charging power based on a result of comparing a specific value calculated from the differential value and a pre-specified threshold value.

At least some of the above and other features of the invention are set out in the claims.

## BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.

FIG. 1 illustrates a schematic configuration of an apparatus for diagnosing and managing a state of a battery according to one embodiment of the present invention;
FIG. 2 illustrates a flow chart for describing a method of diagnosing and managing a state of a battery according to a first embodiment of the present invention;
FIG. 3 illustrates a flow chart for describing a method of diagnosing and managing a state of a battery according to a second embodiment of the present invention; and
FIG. 4 illustrates a flow chart for describing a method of diagnosing and managing a state of a battery according to a third embodiment of the present invention.

## DETAILED DESCRIPTION OF EMBODIMENTS

Hereinafter, embodiments of the present disclosure will be described, in detail, with reference to the accompanying drawings. The terms or words used in this specification and claims should not be construed as being limited to the usual or dictionary meaning and should be interpreted in meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer, or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C," "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to the other element. In addition, when a part is referred to as being "electrically coupled" to another part, the part can be directly connected to another part or an intervening part may be present therebetween such that the part and the other part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

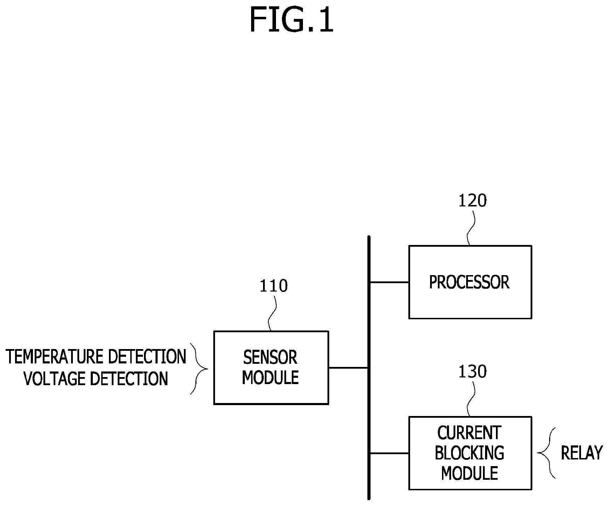

FIG. 1 is a diagram illustrating a schematic configuration of an apparatus for diagnosing and managing a state of a battery according to one embodiment of the present invention.

Referring to FIG. 1, the apparatus for diagnosing and managing the state of the battery according to one embodiment of the present invention includes a sensor module 110, a processor 120, and a current blocking module 130.

The sensor module 110 includes a sensor which detects a temperature of a battery module or battery cell.

The sensor module 110 includes a sensor which detects a voltage of the battery module or battery cell.

The processor 120 may calculate a cell delta voltage (that is, maximum cell voltage value - minimum cell voltage value) of the battery module. In some examples, the maximum and minimum cell voltage values may refer to the highest and lowest cell voltage values that are measured/sensed by the time of calculating the cell delta voltage.

The processor 120 may calculate a differential value of the temperature, voltage, or cell delta voltage of the battery module or battery cell detected through the sensor module 110.

The processor 120 may diagnose an abnormal battery cell or limit power (that is, power input to charge the battery cell) by comparing a value calculated by a specified equation based on the differential value (referred to as a control amount C for convenience) and a plurality of pre-specified threshold values (for example, a first threshold value and a second threshold value).

The current blocking module 130 blocks the power input to charge the battery cell according to control by the processor 120.

The current blocking module 130 includes a relay.

Hereinafter, operations of diagnosing and managing the state of the battery (that is, a concept including the battery module and the battery cell) by the processor 120 will be described in more detail.

**-First Embodiment-**

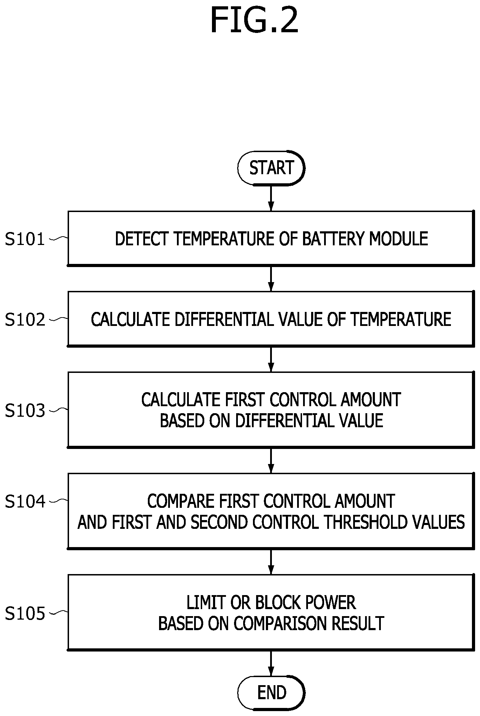

FIG. 2 is a flow chart for describing a method of diagnosing and managing a state of a battery according to a first embodiment of the present invention.

Referring to FIG. 2, the processor 120 detects a temperature T of a battery module (not shown) (S101).

$$\frac{dT}{dt}$$

The processor 120 calculates a differential value ($\frac{dT}{dt}$) of the detected temperature T of the battery module (S 102).

The processor 120 calculates a specific value (referred to as a first control amount C1 for convenience) by

$$\frac{dT}{dt}$$

substituting the differential value ($\frac{dT}{dt}$) into the following specified Equation 1 (S103).

[Equation 1]

$$\text{First control amount} \ (C1) = \alpha T + \beta \frac{dT}{dt}$$

Here, T is the temperature of the battery module, $\alpha$ refers to a weight of the temperature, $\beta$ refers to a weight of a temperature variation amount, and $\alpha$ and 6 may be set in advance using experimental data.

The processor 120 compares the first control amount C1 and pre-specified first and second control threshold values CONTROL_THRESHOLD1 and CONTROL_THRESHOLD2 (S104). Here, the first control threshold value CONTROL_THRESHOLD1 is a value less than the second control threshold value CONTROL_THRESHOLD2.

As a result of the comparison (S104), when the first control amount C1 is greater than the first control threshold value CONTROL_THRESHOLD1 (that is, CONTROL_THRESHOLD1 < first control amount C1 ≤ CONTROL_THRESHOLD2), the processor 120 limits the power (that is, power input to charge the battery cell), and when the first control amount C1 is greater than the second control threshold value CONTROL_THRESHOLD2 (that is, first control amount C1 > CONTROL_THRESHOLD2), power input to the battery through the current blocking module 130 (for example, the relay) is blocked (S105).

As described above, in this embodiment, since it is determined that the temperature tends to rise quickly as the

$$\frac{dT}{dt}$$

differential value ($\frac{dT}{dt}$) of the temperature T of the battery module increases even when the temperature T of the battery module does not reach a temperature threshold value TEMP_THRESHOLD, a rise in temperature may be prevented or substantially reduced by allowing current limiting (or current blocking) to be performed early even when the temperature T of the battery module does not reach the temperature threshold value TEMP_THRESHOLD.

In the present embodiment, there is an effect that battery overheating prevention performance can be improved by determining the battery module overheating possibility early to prevent the temperature of the battery module from reaching an extreme temperature.

**-Second Embodiment-**

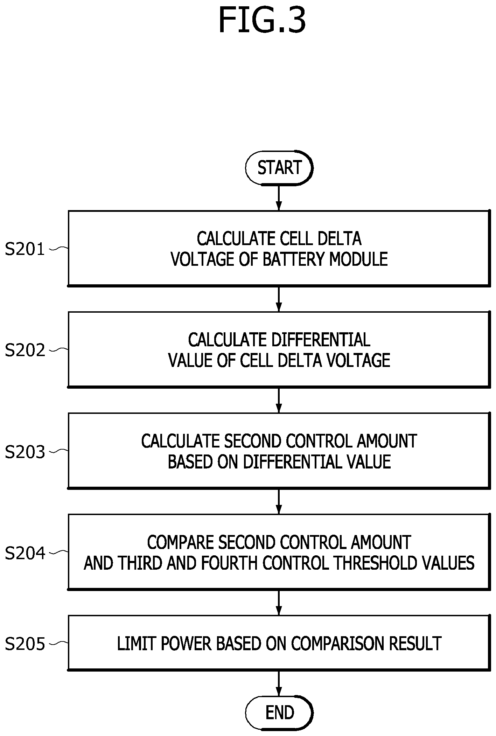

FIG. 3 is a flow chart for describing a method of diagnosing and managing a state of a battery according to a second embodiment of the present invention.

Referring to FIG. 3, the processor 120 detects a cell delta voltage (that is, maximum cell voltage value - minimum cell voltage value) of the battery module (not shown) (S201).

The processor 120 calculates a differential value ($\frac{dV}{dt}$) of the cell delta voltage V (S202).

The processor 120 calculates a specific value (referred to as a second control amount C2 for convenience) by substituting the differential value ($\frac{dV}{dt}$) of the cell delta voltage into the following specified Equation 2 (S203).

[Equation 2]

$$\text{Second control amount } (C2) = \alpha V + \beta \frac{dV}{dt}$$

Here, V is the cell delta voltage, $\alpha$ refers to a weight of the cell delta voltage, $\beta$ refers to a weight of a variation amount in V over time, and $\alpha$ and $\beta$ may be set in advance using experimental data.

The processor 120 compares the second control amount C2 and pre-specified third and fourth control threshold values CONTROL_THRESHOLD3 and CONTROL_THRESHOLD4 (S204). Here, the third control threshold value CONTROL_THRESHOLD3 is a value less than the fourth control threshold value CONTROL_THRESHOLD4.

As a result of the comparison (S204), when the second control amount C2 is greater than the third control threshold value CONTROL_THRESHOLDS (that is, CONTROL_THRESHOLD3 < second control amount C2 ≤ CONTROL_THRESHOLD4), the processor 120 performs cell balancing, and when the second control amount C2 is greater than the fourth control threshold value CONTROL_THRESHOLD4 (that is, second control amount C2 > CONTROL_THRESHOLD4), it is determined to be a cell deviation fault (S205).

As described above, in this embodiment, since it is determined that a voltage difference between cells tends to increase quickly as the differential value ($\frac{dV}{dt}$) of the cell delta voltage V increases even when the cell delta voltage V does not reach a voltage threshold value V_THRESHOLD, the voltage difference between cells may be decreased by allowing cell balancing to be performed early.

In the present embodiment, there is an effect that cell imbalance detection performance can be improved even in a cell voltage fluctuation situation.

Meanwhile, when there is an abnormal battery cell, the abnormal battery cell may be detected using the cell delta voltage.

In this case, the voltage of the abnormal battery cell decreases more quickly than the voltages of other battery cells, and in this case, the cell delta voltage may be reduced by performing cell balancing. However, since the voltage in the abnormal battery cell quickly decreases and thus the cell delta voltage increases again, that is, since the cell delta voltage quickly increases and decreases even when there is the abnormal battery cell, there is a problem in that diagnosis (determination) of the abnormal battery cell is delayed.

That is, since the cell delta voltage is maintained within a specified range by cell balancing even when the abnormal battery cell is diagnosed, there is a problem in that the timing of the diagnosis (determination) of the abnormal battery cell may be delayed.

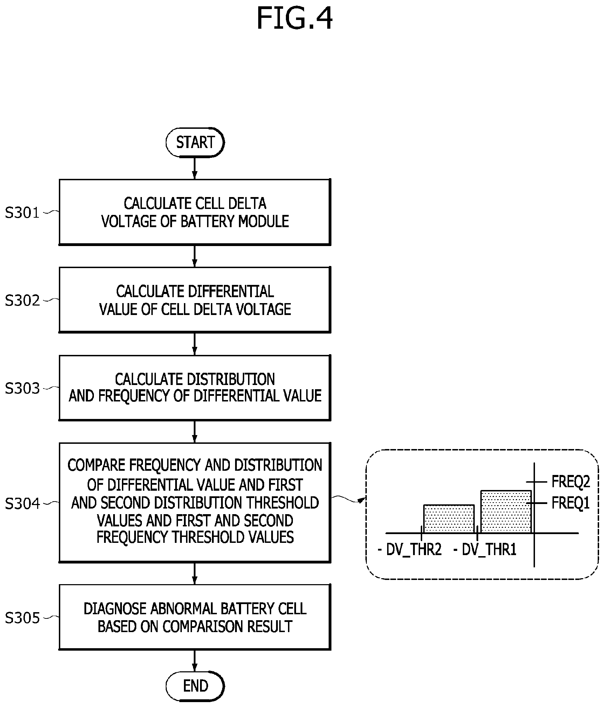

Accordingly, a method capable of detecting an abnormal battery cell without being influenced by cell balancing will be described with reference to FIG. 4.

**-Third Embodiment-**

FIG. 4 is a flow chart for describing a method of diagnosing and managing a state of a battery according to a third embodiment of the present invention.

Referring to FIG. 4, the processor 120 detects a cell delta voltage (that is, maximum cell voltage value - minimum cell voltage value) of the battery module (not shown) (S301).

The processor 120 calculates a differential value ( $\frac{dV}{dt}$ ) of the cell delta voltage V in real time (S302).

Here, V is the cell delta voltage, and dt is a unit time (for example 10 to 100 ms).

The processor 120 calculates the distribution and frequency of the differential value ( $\frac{dV}{dt}$ ) of the cell delta voltage V during a specified period of time (for example, one second) (S303).

In this case, since a voltage decrease rate is important for diagnosing an abnormal battery cell, the distribution and frequency may be calculated only for the voltage decrease rate.

The processor 120 compares the distribution and frequency of the differential value ( $\frac{dV}{dt}$ ) of the cell delta voltage V and pre-specified first and second distribution threshold values DV_THR1 and DV_THR2 and first and second frequency threshold values FREQ1 and FREQ2 (S304).

Here, the second distribution threshold value DV_THR2 is a value greater than the first distribution threshold value DV_THR1, and the second frequency threshold value FREQ2 is a value greater than the first frequency threshold value FREQ1.

For example, the distribution of the differential value ( $\frac{dV}{dt}$ ) of the cell delta voltage V during a specified period of time (for example, one second) is one of less than the first distribution threshold value DV THR1, greater than or equal to the first distribution threshold value DV_THR1 and less than the second distribution threshold value DV_THR2, and greater than or equal to the second distribution threshold value DV_THR2. Further, for example, the frequency of the differential value ( $\frac{dV}{dt}$ ) of the cell delta voltage V during a specified period of time (for example, one second) is one of less than the first frequency threshold value FREQ1, greater than or equal to the first frequency threshold value FREQ1 and less than the second frequency threshold value FREQ2, and greater than or equal to the second frequency threshold value FREQ2.

As a result of the comparison (S304), the processor diagnoses a cell with a minimum cell delta voltage value as the abnormal battery cell when the frequency of the distribution, in which the distribution of the differential value ( $\frac{dV}{dt}$ ) of the cell delta voltage V during a specified period of time (for example, one second) is less than the first distribution threshold value DV_THR1, is greater than the second frequency threshold value FREQ2, or when the frequency of distribution, in which the distribution is greater than or equal to the first distribution threshold value DV_THR1 and less than the second distribution threshold value DV THR2, is greater than the first frequency threshold value FREQ1 (S305).

In this embodiment, the distribution of the differential value of the cell delta voltage over time is accumulated for a specified period of time to diagnose an abnormal battery cell according to the accumulated frequency for each distribution. That is, in the present embodiment, there is an effect of allowing diagnosis of an abnormal battery cell without being influenced by cell balancing by diagnosing the abnormal battery cell based on the frequency for each distribution of the differential value of the cell delta voltage over time.

Implementations described in the present specification may be implemented as, for example, a method or process, device, software program, data stream, or signal. Although only the context of a singular form of implementation is discussed (for example, only a method is discussed), implementations of discussed features may also be implemented in another form (for example, a device or program). The device may be implemented with appropriate hardware, software, firmware, and the like. The method may be implemented in devices such as processors, which generally refer to processing devices that include computers, microprocessors, integrated circuits, programmable logic devices, or the like. Further, the processors include communication devices such as computers, cellular phones, portable/personal digital assistants (PDAs), other devices, etc. that facilitate the communication of information between end-users.

According to the present invention, the time for diagnosing and managing of the state of battery cells can be shortened and the accuracy of determination can be further improved.

Further, according to the present invention, a temperature of the battery cells is detected, a differential value of the temperature is extracted, and the temperature of the battery cells is controlled according to the extracted differential value to prevent overheating of the battery cells.

In addition, according to the present invention, the occurrence of a cell imbalance can be determined based on a differential value of a cell delta voltage to perform cell balancing and current control.

In addition, according to the present invention, an abnormal cell can be detected based on distribution of a differential value of the cell delta voltage over time to exclude the influence of cell balancing and effectively detect the abnormal cell.

Embodiments are set out in the following clauses:

1. An apparatus for diagnosing and managing a state of a battery, the apparatus comprising:

a sensing device configured to detect a temperature and a voltage of the battery; and
a processor configured to calculate a cell delta voltage based on at least one of the temperature or the voltage of the battery, to calculate a differential value of the temperature, the voltage, or the cell delta voltage, to diagnose an abnormal battery cell or to limit battery charging power based on a threshold value and the differential value.

2. The apparatus of clause 1, further comprising:
a current blocking device comprising a switch and configured to block battery charging power based on a control signal from the processor.

3. The apparatus of clause 1 or 2, wherein the processor is configured to detect the temperature of the battery, to calculate the differential value of the temperature of the battery, and to limit charging power of the battery based on a result of comparing a specific value and the threshold value, the specific value being expressed as:

$$specific\ value = \alpha T + \beta \frac{dT}{dt}$$

where, $T$ is the temperature of the battery, $\alpha$ refers to a weight of the temperature, $\frac{dT}{dt}$ refers to the differential value of the temperature, and $\beta$ refers to a weight of the differential value.

4. The apparatus of clause 1, 2 or 3, wherein the processor is configured to calculate the differential value of the cell delta voltage, and to performs cell balancing or to determines a cell deviation fault based on a result of comparing a specific value and the threshold value, the specific value being expressed as:

$$specific\ value = \alpha V + \beta \frac{dV}{dt}$$

where, V is the cell delta voltage, $\alpha$ refers to a weight of the cell delta voltage, $\frac{dV}{dt}$ refers to the differential value of the cell delta voltage, and $\beta$ refers to a weight of the differential value of the cell delta voltage.

5. The apparatus of any preceding clause, wherein the processor is configured to calculate the cell delta voltage of the battery, to calculate the differential value of the cell delta voltage in real time, to calculate a distribution and a frequency of the differential value of the cell delta voltage during a period of time, and to diagnose the abnormal battery cell based on a result of comparing the distribution and the frequency of the differential value of the cell delta voltage and first and second distribution threshold values and first and second frequency threshold values.

6. A method of diagnosing and managing a state of a battery, the method comprising:

detecting, by a processor, a temperature of the battery;
calculating, by the processor, a differential value of the temperature of the battery; and
limiting, by the processor, charging power of the battery based on a result of comparing a threshold value and a specific value calculated from the differential value of the temperature of the battery.

7. The method of clause 6, wherein the processor is configured to calculate a first control amount as the specific value based on Equation 1, the first control amount being expressed as:

$$first\ control\ amount = \alpha T + \beta \frac{dT}{dt}$$

where, $T$ is the temperature of the battery, $\alpha$ refers to a weight of the temperature, $\frac{dT}{dt}$ refers to the differential value of the temperature, and $\beta$ refers to a weight of the differential value.

8. The method of clause 7, wherein, in the comparing of the threshold value and the specific value, the processor is configured to compare the first control amount with a first control threshold value and a second control threshold value.

9. The method of clause 7 or 8, wherein, in the limiting of the charging power of the battery based on the result of the comparing, the processor is configured to limit the charging power in response to the first control amount being greater than a first control threshold value.

10. The method of clause 7, 8 or 9, wherein, in the limiting of the charging power of the battery based on the result of the comparing, the processor is configured to block power input to the battery through a power blocker in response to the first control amount (C1) being greater than a second control threshold value.

11. A method of diagnosing and managing a state of a battery, the method comprising:

   calculating, by a processor, a cell delta voltage of the battery;
   calculating, by the processor, a differential value of the cell delta voltage; and
   performing, by the processor, cell balancing or determining a cell deviation fault based on a result of comparing a threshold value and a specific value calculated from the differential value of the cell delta voltage.

12. The method of clause 11, wherein the cell delta voltage is a voltage calculated by subtracting a minimum cell voltage value from a maximum cell voltage value.

13. The method of clause 11 or 12, wherein the processor is configured to calculate a second control amount as the specific value, the second control amount being expressed as:

$$second\ control\ amount = \alpha V + \beta \frac{dV}{dt}$$

where, V is the cell delta voltage, $\alpha$ refers to a weight of the cell delta voltage, $\frac{dV}{dt}$ refers to the differential value of the cell delta voltage, and $\beta$ refers to a weight of the differential value of the cell delta voltage.

14. The method of clause 13, wherein, in the comparing of the threshold value and the specific value, the processor is configured to compare the second control amount with a third control threshold value and a fourth control threshold value.

15. The method of clause 13 or 14, wherein, in the performing of the cell balancing, the processor is configured to perform cell balancing in response to the second control amount being greater than a third control threshold value.

16. The method of clause 13, 14 or 15, wherein, in the determining of the cell deviation fault, the processor is configured to determine the cell deviation fault in response to the second control amount being greater than a fourth control threshold value.

17. The method of any one of clauses 11 to 16, further comprising:

calculating, by the processor, a distribution and a frequency of the differential value of the cell delta voltage during a period of time; and

diagnosing, by the processor, an abnormal battery cell based on a result of comparing the distribution and the frequency of the differential value of the cell delta voltage with first and second distribution threshold values and first and second frequency threshold values.

18. The method of clause 17, wherein the distribution of the differential value of the cell delta voltage comprises one of values less than the first distribution threshold value, values greater than or equal to the first distribution threshold value and less than the second distribution threshold value, and values greater than or equal to the second distribution threshold value.

19. The method of clause 17 or 18, wherein the frequency of the differential value of the cell delta voltage comprises one of a value less than the first frequency threshold value, a value greater than or equal to the first frequency threshold value and less than the second frequency threshold value, and a value greater than or equal to the second frequency threshold value.

20. The method of clause 17, 18, or 19, wherein, in the diagnosing of the abnormal battery cell, the processor is configured to diagnose a cell with a minimum cell delta voltage value as the abnormal battery cell in response to the frequency of distribution, in which the differential value of the cell delta voltage during the period of time is less than the first distribution threshold value , is greater than the second frequency threshold value, or in response to the frequency of a distribution, which is greater than or equal to the first distribution threshold value and less than the second distribution threshold value, is greater than the first frequency threshold value.

21. An apparatus for diagnosing and managing a state of a battery, comprising:

a sensor module configured to detect a temperature and a voltage of a battery; and

a processor configured to calculate a cell delta voltage based on the temperature or voltage of the battery detected through the sensor module, calculate a differential value of the temperature, voltage, or cell delta voltage, and diagnose an abnormal battery cell or limit battery charging power based on a result of comparing a specific value calculated by substituting the differential value into a specified equation and a pre-specified threshold value.

22. The apparatus of clause 21, further comprising a current blocking module configured to block battery charging power according to control of the processor,

wherein the current blocking module includes a relay.

23. The apparatus of clause 21 or 22, wherein the processor detects a temperature (T) of a battery module, calculates a differential value ($\frac{dT}{dt}$) of the temperature (T) of the battery module, and limits charging power of the battery based on a result of comparing a specific value calculated by substituting the differential value ($\frac{dT}{dt}$) of the temperature (T) of the battery module into specified Equation 1 and a pre-specified threshold value,

(Equation 1)

$$\text{First control amount } (C1) = \alpha\, T + \beta \frac{dT}{dt}$$

Here, T is the temperature of the battery module, $\alpha$ refers to a weight of the temperature, and $\beta$ refers to a weight of a temperature variation amount.

24. The apparatus of clause 21, 22 or 23, wherein the processor calculates a cell delta voltage (V) of a battery module, calculates a differential value ($\frac{dV}{dt}$) of the cell delta voltage (V), and performs cell balancing or determines a cell deviation fault based on a result of comparing a specific value calculated by substituting the differential value ($\frac{dV}{dt}$) of the cell delta voltage (V) into specified Equation 2 and a pre-specified threshold value,

(Equation 2)

$$\text{Second control amount } (C2) = \alpha\,V + \beta\frac{dV}{dt}$$

Here, V is the cell delta voltage, $\alpha$ refers to a weight of the cell delta voltage, and $\beta$ refers to a weight of a variation amount in V over time.

25. A method of diagnosing and managing a state of a battery, comprising:

detecting, by a processor, a temperature (T) of a battery module;
calculating, by the processor, a differential value of the temperature (T) of the battery module; and
limiting, by the processor, charging power of the battery based on a result of comparing a specific value calculated from the differential value of the temperature (T) of the battery module and a pre-specified threshold value.

26. The method of clause 25, wherein the processor calculates a first control amount (C1) as the specific value based on Equation 1,

(Equation 1)

$$\text{First control amount } (C1) = \alpha\,T + \beta\frac{dT}{dt}$$

Here, T is the temperature of the battery module, $\alpha$ refers to a weight of the temperature, and 6 refers to a weight of a temperature variation amount.

27. The method of clause 25 or 26, wherein, in the limiting of charging power of the battery based on the result of comparing the specific value and the pre-specified threshold value, the processor limits the charging power when the first control amount (C1) is greater than a first control threshold value (CONTROL_THRESHOLD1).

28. The method of clause 25, 26 or 27, wherein, in the limiting of charging power of the battery based on the result of comparing the specific value and the pre-specified threshold value, the processor blocks power input to the battery through a power blocking module when the first control amount (C1) is greater than a second control threshold value (CONTROL_THRESHOLD2).

29. A method of diagnosing and managing a state of a battery, comprising:

calculating, by a processor, a cell delta voltage (V) of a battery module;
calculating, by the processor, a differential value of the cell delta voltage (V); and
performing, by the processor, cell balancing or determining a cell deviation fault based on a result of comparing a specific value calculated from the differential value of the cell delta voltage (V) and a pre-specified threshold value.

30. The method of clause 29, wherein the cell delta voltage is a voltage calculated by 'maximum cell voltage value - minimum cell voltage value.'

31. The method of clause 29 or 30, wherein the processor calculates a second control amount (C2) as the specific value based on Equation 2,

$$\text{(Equation 2)}$$

$$\text{Second control amount } (C2) = \alpha\, V + \beta \frac{dV}{dt}$$

Here, V is the cell delta voltage, $\alpha$ refers to a weight of the cell delta voltage, and $\beta$ a weight of a variation amount in V over time.

32. The method of clause 29, 30 or 31, wherein, in the performing of cell balancing based on the result of comparing the specific value and the pre-specified threshold value, the processor performs cell balancing when the second control amount (C2) is greater than a third control threshold value (CONTROL_THRESHOLD3).

33. The method of any one of clauses 29 to 32, wherein, in the determining of a cell deviation fault based on the result of comparing the specific value and the pre-specified threshold value, the processor determines the cell deviation fault when the second control amount (C2) is greater than a fourth control threshold value (CONTROL THRESHOLD4).

34. The method of any one of clauses 29 to 33, further comprising: after calculating the differential value ($\frac{dV}{dt}$) of the cell delta voltage (V), calculating, by the processor, a distribution and frequency of the differential value ($\frac{dV}{dt}$) of the cell delta voltage (V) during a specified period of time; and diagnosing, by the processor, an abnormal battery cell based on a result of comparing the distribution and the frequency of the differential value ($\frac{dV}{dt}$) of the cell delta voltage (V) and pre-specified first and second distribution threshold values (DV_THR1 and DV_THR2) and first and second frequency threshold values (FREQ1 and FREQ2).

35. The method of clause 34, wherein the distribution of the differential value ($\frac{dV}{dt}$) of the cell delta voltage (V) includes one of less than the first distribution threshold value (DV THR1), greater than or equal to the first distribution threshold value (DV_THR1) and less than the second distribution threshold value (DV THR2), and greater than or equal to the second distribution threshold value (DV_THR2).

**Claims**

1. An apparatus for diagnosing and managing a state of a battery, the apparatus comprising:

   a sensor module configured to detect a temperature and a voltage of the battery; and
   a processor configured to calculate a cell delta voltage based on the temperature or voltage of the battery detected through the sensor module, calculate a differential value of the temperature, voltage, or cell delta voltage, and diagnose an abnormal battery cell or limit battery charging power based on a result of comparing a specific value calculated from the differential value and a pre-specified threshold value.

2. The apparatus of claim 1, further comprising a current blocking module configured to block battery charging power according to control by the processor,

wherein the current blocking module includes a switch or relay.

3. The apparatus of claim 1 or 2, wherein the processor detects a temperature (T) of the battery, calculates a differential value ($\frac{dT}{dt}$) of the temperature (T) of the battery, and limits charging power of the battery based on a result of comparing a specific value calculated by substituting the differential value ($\frac{dT}{dt}$) of the temperature (T) of the battery into specified Equation 1 and a pre-specified threshold value,

(Equation 1)

$$\text{First control amount} \ (C1) = \alpha\,T + \beta\frac{dT}{dt}$$

where T is the temperature of the battery, $\alpha$ refers to a weight of the temperature, and $\beta$ refers to a weight of a temperature variation amount.

4. The apparatus of claim 1, 2 or 3, wherein the processor calculates a cell delta voltage (V) of the battery, calculates a differential value ($\frac{dV}{dt}$) of the cell delta voltage (V), and performs cell balancing or determines a cell deviation fault based on a result of comparing a specific value calculated by substituting the differential value ($\frac{dV}{dt}$) of the cell delta voltage (V) into specified Equation 2 and a pre-specified threshold value,

(Equation 2)

$$\text{Second control amount} \ (C2) = \alpha\,V + \beta\frac{dV}{dt}$$

where V is the cell delta voltage, $\alpha$ refers to a weight of the cell delta voltage, and $\beta$ refers to a weight of a variation amount in V over time.

5. A method of diagnosing and managing a state of a battery, the method comprising:

   detecting, by a processor, a temperature (T) of the battery;
   calculating, by the processor, a differential value of the temperature (T) of the battery; and
   limiting, by the processor, charging power of the battery based on a result of comparing a specific value calculated from the differential value of the temperature (T) of the battery and a pre-specified threshold value.

6. The method of claim 5, wherein the processor calculates a first control amount (C1) as the specific value based on Equation 1,

(Equation 1)

$$\text{First control amount } (C1) = \alpha T + \beta \frac{dT}{dt}$$

where T is the temperature of the battery, $\alpha$ refers to a weight of the temperature, and $\beta$ refers to a weight of a temperature variation amount.

7. The method of claim 6, wherein, in the limiting of charging power of the battery based on the result of comparing the specific value and the pre-specified threshold value, the processor limits the charging power when the first control amount (C1) is greater than a first control threshold value (CONTROL_THRESHOLD1).

8. The method of claim 6 or 7, wherein, in the limiting of charging power of the battery based on the result of comparing the specific value and the pre-specified threshold value, the processor blocks power input to the battery through a power blocking module when the first control amount (C1) is greater than a second control threshold value (CONTROL_THRESHOLD2).

9. A method of diagnosing and managing a state of a battery, comprising:

calculating, by a processor, a cell delta voltage (V) of the battery;
calculating, by the processor, a differential value of the cell delta voltage (V); and
performing, by the processor, cell balancing or determining a cell deviation fault based on a result of comparing a specific value calculated from the differential value of the cell delta voltage (V) and a pre-specified threshold value.

10. The method of claim 9, wherein the cell delta voltage is a voltage calculated by 'maximum cell voltage value - minimum cell voltage value.'

11. The method of claim 9 or 10, wherein the processor calculates a second control amount (C2) as the specific value based on Equation 2,

(Equation 2)

$$\text{Second control amount } (C2) = \alpha V + \beta \frac{dV}{dt}$$

where V is the cell delta voltage, $\alpha$ refers to a weight of the cell delta voltage, and $\beta$ refers to a weight of a variation amount in V over time.

12. The method of claim 11, wherein, in the performing of cell balancing based on the result of comparing the specific value and the pre-specified threshold value, the processor performs cell balancing when the second control amount (C2) is greater than a third control threshold value (CONTROL_THRESHOLD3).

13. The method of claim 11 or 12, wherein, in the determining of a cell deviation fault based on the result of comparing the specific value and the pre-specified threshold value, the processor determines the cell deviation fault when the second control amount (C2) is greater than a fourth control threshold value (CONTROL_THRESHOLD4).

14. The method of any one of claims 9 to 13, further comprising, after calculating the differential value ($\frac{dV}{dt}$) of the cell delta voltage (V):

calculating, by the processor, a distribution and frequency of the differential value ($\frac{dV}{dt}$) of the cell delta voltage (V) during a specified period of time; and diagnosing, by the processor, an abnormal battery cell based on a result of comparing the distribution and the frequency of the differential value ($\frac{dV}{dt}$) of the cell delta voltage (V) and pre-specified first and second distribution threshold values (DV_THR1 and DV_THR2) and first and second frequency threshold values (FREQ1 and FREQ2).

15. The method of claim 14, wherein the distribution of the differential value ($\frac{dV}{dt}$) of the cell delta voltage (V) includes one of: less than the first distribution threshold value (DV THR1), greater than or equal to the first distribution threshold value (DV_THR1) and less than the second distribution threshold value (DV THR2), and greater than or equal to the second distribution threshold value (DV_THR2).

# FIG.1

120

PROCESSOR

110

TEMPERATURE DETECTION
VOLTAGE DETECTION

SENSOR
MODULE

130

CURRENT
BLOCKING
MODULE

RELAY

# FIG.2

```
                    ( START )
                        |
                        v
S101 ─┌─────────────────────────────────────────┐
      │   DETECT TEMPERATURE OF BATTERY MODULE   │
      └─────────────────────────────────────────┘
                        |
                        v
S102 ─┌─────────────────────────────────────────┐
      │  CALCULATE DIFFERENTIAL VALUE OF TEMPERATURE │
      └─────────────────────────────────────────┘
                        |
                        v
S103 ─┌─────────────────────────────────────────┐
      │      CALCULATE FIRST CONTROL AMOUNT       │
      │       BASED ON DIFFERENTIAL VALUE         │
      └─────────────────────────────────────────┘
                        |
                        v
S104 ─┌─────────────────────────────────────────┐
      │       COMPARE FIRST CONTROL AMOUNT        │
      │ AND FIRST AND SECOND CONTROL THRESHOLD VALUES │
      └─────────────────────────────────────────┘
                        |
                        v
S105 ─┌─────────────────────────────────────────┐
      │          LIMIT OR BLOCK POWER             │
      │       BASED ON COMPARISON RESULT          │
      └─────────────────────────────────────────┘
                        |
                        v
                    (  END  )
```

# FIG.3

START

S201 ── CALCULATE CELL DELTA
VOLTAGE OF BATTERY MODULE

S202 ── CALCULATE DIFFERENTIAL
VALUE OF CELL DELTA VOLTAGE

S203 ── CALCULATE SECOND CONTROL AMOUNT
BASED ON DIFFERENTIAL VALUE

S204 ── COMPARE SECOND CONTROL AMOUNT
AND THIRD AND FOURTH CONTROL THRESHOLD VALUES

S205 ── LIMIT POWER BASED ON COMPARISON RESULT

END

# FIG.4

START

S301 — CALCULATE CELL DELTA
VOLTAGE OF BATTERY MODULE

S302 — CALCULATE DIFFERENTIAL
VALUE OF CELL DELTA VOLTAGE

S303 — CALCULATE DISTRIBUTION
AND FREQUENCY OF DIFFERENTIAL VALUE

S304 — COMPARE FREQUENCY AND DISTRIBUTION
OF DIFFERENTIAL VALUE AND FIRST
AND SECOND DISTRIBUTION THRESHOLD
VALUES AND FIRST AND SECOND
FREQUENCY THRESHOLD VALUES

FREQ2
FREQ1

- DV_THR2   - DV_THR1

S305 — DIAGNOSE ABNORMAL BATTERY CELL
BASED ON COMPARISON RESULT

END

Europäisches
Patentamt

European
Patent Office

Office européen
des brevets

# EUROPEAN SEARCH REPORT

**Application Number**

EP 24 16 6082

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CA 3 071 151 A1 (NORTHSTAR BATTERY CO LLC [US]) 31 January 2019 (2019-01-31) * paragraphs [0113] - [0116] * ----- | 1-15 | INV. H02J7/00 |
| X | US 2021/404146 A1 (ISHIDA SEIJI [JP] ET AL) 30 December 2021 (2021-12-30) * paragraphs [0002] - [0008] * ----- | 1-15 | |

**TECHNICAL FIELDS SEARCHED (IPC)**

H02J

The present search report has been drawn up for all claims

| Place of search | Date of completion of the search | Examiner |
|---|---|---|
| Munich | 9 October 2024 | Ramcke, Ties |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................................
& : member of the same patent family, corresponding
document

EPO FORM 1503 03.82 (P04C01)

**ANNEX TO THE EUROPEAN SEARCH REPORT**
**ON EUROPEAN PATENT APPLICATION NO.**                    EP 24 16 6082

This annex lists the patent family members relating to the patent documents cited in  the above-mentioned European search report.
The members are as contained in the European Patent Office EDP file on
The European Patent Office is in no way liable for these particulars which are merely given for the purpose of information.

09-10-2024

| Patent document cited in search report | | Publication date | Patent family member(s) | | Publication date |
|---|---|---|---|---|---|
| CA 3071151 | A1 | 31-01-2019 | CA | 3070566 A1 | 31-01-2019 |
| | | | CA | 3071116 A1 | 31-01-2019 |
| | | | CA | 3071118 A1 | 31-01-2019 |
| | | | CA | 3071121 A1 | 31-01-2019 |
| | | | CA | 3071122 A1 | 31-01-2019 |
| | | | CA | 3071124 A1 | 31-01-2019 |
| | | | CA | 3071126 A1 | 31-01-2019 |
| | | | CA | 3071141 A1 | 31-01-2019 |
| | | | CA | 3071146 A1 | 31-01-2019 |
| | | | CA | 3071151 A1 | 31-01-2019 |
| | | | CA | 3071154 A1 | 31-01-2019 |
| | | | CA | 3071157 A1 | 31-01-2019 |
| | | | CA | 3071666 A1 | 31-01-2019 |
| | | | CN | 111108401 A | 05-05-2020 |
| | | | CN | 111108402 A | 05-05-2020 |
| | | | CN | 111108404 A | 05-05-2020 |
| | | | CN | 111133325 A | 08-05-2020 |
| | | | CN | 111149007 A | 12-05-2020 |
| | | | CN | 111149008 A | 12-05-2020 |
| | | | CN | 111149009 A | 12-05-2020 |
| | | | CN | 111149010 A | 12-05-2020 |
| | | | CN | 111164435 A | 15-05-2020 |
| | | | CN | 111164439 A | 15-05-2020 |
| | | | CN | 111164440 A | 15-05-2020 |
| | | | CN | 111164441 A | 15-05-2020 |
| | | | CN | 111164821 A | 15-05-2020 |
| | | | CN | 111183461 A | 19-05-2020 |
| | | | EP | 3658932 A1 | 03-06-2020 |
| | | | EP | 3658933 A1 | 03-06-2020 |
| | | | EP | 3658934 A1 | 03-06-2020 |
| | | | EP | 3658935 A2 | 03-06-2020 |
| | | | EP | 3658936 A1 | 03-06-2020 |
| | | | EP | 3658937 A1 | 03-06-2020 |
| | | | EP | 3658938 A2 | 03-06-2020 |
| | | | EP | 3658939 A1 | 03-06-2020 |
| | | | EP | 3658940 A1 | 03-06-2020 |
| | | | EP | 3658941 A1 | 03-06-2020 |
| | | | EP | 3658942 A2 | 03-06-2020 |
| | | | EP | 3658943 A1 | 03-06-2020 |
| | | | EP | 3659129 A1 | 03-06-2020 |
| | | | EP | 3659203 A1 | 03-06-2020 |
| | | | ES | 2924278 T3 | 05-10-2022 |
| | | | ES | 2929534 T3 | 30-11-2022 |
| | | | ES | 2970610 T3 | 29-05-2024 |
| | | | JP | 2020528981 A | 01-10-2020 |
| | | | JP | 2020529020 A | 01-10-2020 |

EPO FORM P0459

For more details about this annex : see Official Journal of the European Patent Office, No. 12/82

page 1 of 3

## ANNEX TO THE EUROPEAN SEARCH REPORT
## ON EUROPEAN PATENT APPLICATION NO.

EP 24 16 6082

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2024

| Patent document cited in search report | Publication date | Patent family member(s) | Publication date |
|---|---|---|---|
| | | JP 2020529021 A | 01-10-2020 |
| | | JP 2020529022 A | 01-10-2020 |
| | | JP 2020529024 A | 01-10-2020 |
| | | JP 2020529107 A | 01-10-2020 |
| | | JP 2020529108 A | 01-10-2020 |
| | | JP 2020529109 A | 01-10-2020 |
| | | JP 2020529110 A | 01-10-2020 |
| | | JP 2020529111 A | 01-10-2020 |
| | | JP 2020529112 A | 01-10-2020 |
| | | JP 2020529114 A | 01-10-2020 |
| | | JP 2020529662 A | 08-10-2020 |
| | | JP 2020529663 A | 08-10-2020 |
| | | KR 20200024332 A | 06-03-2020 |
| | | KR 20200024358 A | 06-03-2020 |
| | | KR 20200024359 A | 06-03-2020 |
| | | KR 20200024944 A | 09-03-2020 |
| | | KR 20200027039 A | 11-03-2020 |
| | | KR 20200036893 A | 07-04-2020 |
| | | KR 20200038264 A | 10-04-2020 |
| | | KR 20200038265 A | 10-04-2020 |
| | | KR 20200038267 A | 10-04-2020 |
| | | KR 20200038269 A | 10-04-2020 |
| | | KR 20200049770 A | 08-05-2020 |
| | | KR 20200049771 A | 08-05-2020 |
| | | KR 20200049772 A | 08-05-2020 |
| | | KR 20200050455 A | 11-05-2020 |
| | | US 2019033377 A1 | 31-01-2019 |
| | | US 2019033381 A1 | 31-01-2019 |
| | | US 2019033382 A1 | 31-01-2019 |
| | | US 2019033383 A1 | 31-01-2019 |
| | | US 2019033384 A1 | 31-01-2019 |
| | | US 2019033385 A1 | 31-01-2019 |
| | | US 2019033388 A1 | 31-01-2019 |
| | | US 2019033393 A1 | 31-01-2019 |
| | | US 2019033394 A1 | 31-01-2019 |
| | | US 2019033395 A1 | 31-01-2019 |
| | | US 2019033396 A1 | 31-01-2019 |
| | | US 2019033397 A1 | 31-01-2019 |
| | | US 2019035237 A1 | 31-01-2019 |
| | | US 2019036178 A1 | 31-01-2019 |
| | | US 2022404426 A1 | 22-12-2022 |
| | | WO 2019023629 A2 | 31-01-2019 |
| | | WO 2019023656 A1 | 31-01-2019 |
| | | WO 2019023663 A1 | 31-01-2019 |
| | | WO 2019023666 A1 | 31-01-2019 |
| | | WO 2019023670 A1 | 31-01-2019 |

EPO FORM P0459

For more details about this annex : see Official Journal of the European Patent Office, No. 12/82

page 2 of 3

**ANNEX TO THE EUROPEAN SEARCH REPORT
ON EUROPEAN PATENT APPLICATION NO.**  EP 24 16 6082

This annex lists the patent family members relating to the patent documents cited in  the above-mentioned European search report.
The members are as contained in the European Patent Office EDP file on
The European Patent Office is in no way liable for these particulars which are merely given for the purpose of information.

09-10-2024

| Patent document cited in search report | Publication date | Patent family member(s) | | Publication date |
|---|---|---|---|---|
| | | WO | 2019023671 A1 | 31-01-2019 |
| | | WO | 2019023673 A1 | 31-01-2019 |
| | | WO | 2019023675 A1 | 31-01-2019 |
| | | WO | 2019023678 A1 | 31-01-2019 |
| | | WO | 2019023679 A1 | 31-01-2019 |
| | | WO | 2019023681 A1 | 31-01-2019 |
| | | WO | 2019023682 A2 | 31-01-2019 |
| | | WO | 2019023684 A1 | 31-01-2019 |
| | | WO | 2019023687 A2 | 31-01-2019 |
| US 2021404146 A1 | 30-12-2021 | CN | 110506377 A | 26-11-2019 |
| | | EP | 3767785 A1 | 20-01-2021 |
| | | JP | 6741878 B2 | 19-08-2020 |
| | | JP | WO2019176054 A1 | 16-04-2020 |
| | | KR | 20190111091 A | 01-10-2019 |
| | | US | 2021404146 A1 | 30-12-2021 |
| | | WO | 2019176054 A1 | 19-09-2019 |

EPO FORM P0459

For more details about this annex : see Official Journal of the European Patent Office, No. 12/82

page 3 of 3